# EUROPEAN PATENT SPECIFICATION

(11) **EP 3 200 239 B1**
(45) Date of publication and mention of the grant of the patent: **14.04.2021**
(21) Application number: 15844110.5
(22) Date of filing: 20.08.2015
(51) Int. Cl.: H01L 31/048, H01L 31/05

(54) **SOLAR CELL MODULE AND METHOD FOR MANUFACTURING SOLAR CELL MODULE**
SOLARZELLENMODUL UND VERFAHREN ZUR HERSTELLUNG DES SOLARZELLENMODULS
MODULE SOLAIRE ET SON PROCÉDÉ DE FABRICATION

(30) Priority: 22.09.2014 JP 2014192732
(43) Date of publication of application: 02.08.2017
(73) Proprietor: Panasonic Intellectual Property Management Co., Ltd., Osaka-shi, Osaka 540-6207 (JP)
(72) Inventor: KOUYANAGI, Masao, Osaka 540-6207 (JP); YAMASHITA, Mamoru, Osaka 540-6207 (JP); ICHINOSE, Hitomi, Osaka 540-6207 (JP); NAKAMURA, Takahiro, Osaka 540-6207 (JP)
(74) Representative: Müller-Boré & Partner Patentanwälte PartG mbB
(86) International application number: PCT/JP2015/004167
(87) International publication number: WO 2016/047029

(56) References cited:
- WO-A1-2014/030225
- JP-A- 2009 246 208
- JP-A- 2009 246 208
- JP-A- 2012 019 078
- JP-A- 2012 033 546
- JP-A- 2014 138 068
- US-A1- 2012 152 330

## Description

### TECHNICAL FIELD

The present invention relates to a solar cell module and a method for manufacturing a solar cell module.

### BACKGROUND ART

Solar cell modules have been conventionally developed as photoelectric conversion devices for converting light energy into electric energy. Solar cell modules are expected to serve as a new energy source, as they can convert inexhaustible sunlight directly into electricity and also are environmentally friendly and clean as compared with fossil fuel power generation.

This type of solar cell module has, for example, a structure in which a plurality of solar cells are sealed with a filler between a light-transmitting substrate and a back sheet. For example, the solar cell module includes: a glass substrate located on the light receiving surface side; a back sheet; a plurality of solar cells arranged in a matrix between the glass substrate and the back sheet; and a filling member filling the space between the back sheet and the glass substrate (for example, JP 2007-150069 A).

A plurality of solar cells arranged in one of the row direction and column direction are made into a cell string by connecting adjacent solar cells by tab wires. Transition wires are provided at both ends of the solar cell module, and the first and last solar cells in each of a plurality of cell strings are connected to the transition wires via the tab wires.

Further, JP 2009-246208 A describes a solar cell module comprising a light reception surface-side sealing layer, a back-side sealing layer, and a plurality of solar cell elements laminated on the light reception surface-side sealing layer. Lateral wiring cover layers are stacked on the light reception surface-side sealing layer, lateral wiring sealing layers are laminated on the lateral wiring cover layers to expose the respective ends on the respective solar cell element side. Furthermore, lateral wires are laminated on the lateral wiring sealing layers and connect respective tab wires to one another.

### SUMMARY OF THE INVENTION

### TECHNICAL PROBLEM

The transition wires, however, have metallic luster in appearance, and so are noticeable in the case where the solar cell module is seen from the light receiving surface side. This causes a problem of poor design of the whole appearance of the solar cell module.

To conceal the transition wires, the transition wires may be covered with a concealment sheet from the light receiving surface side. The placement of the concealment sheet can, however, degrade design, and also degrade workability.

The present invention has been made to solve the problem stated above, and has an object of providing a solar cell module that can conceal transition wires without degrading design and workability.

### SOLUTION TO PROBLEM

The problem stated above is solved by the subject-matter disclosed in the independent claims. Preferred embodiments are defined in the dependent claims.

### ADVANTAGEOUS EFFECT OF INVENTION

It is thus possible to conceal transition wires without degrading design and workability.

### BRIEF DESCRIPTION OF DRAWINGS

FIG. 1 is a plan view of a solar cell module according to an embodiment.
FIG. 2 is a partially enlarged sectional view (sectional view along line A-A in FIG. 1) of the solar cell module according to the embodiment.
FIG. 3 is a view for describing a lamination process in the solar cell module according to the embodiment.
FIG. 4A is a sectional view (sectional view before lamination) illustrating the structure of a solar cell module according to a comparative example.
FIG. 4B is a sectional view (sectional view after lamination) illustrating the structure of the solar cell module according to the comparative example.

### DESCRIPTION OF EXEMPLARY EMBODIMENT

The following describes an embodiment of the present invention with reference to drawings. The embodiment described below shows a specific example of the present invention. The numerical values, shapes, materials, structural elements, the arrangement and connection of the structural elements, etc. shown in the following embodiment are mere examples, and do not limit the scope of the present invention. Of the structural elements in the embodiment described below, the structural elements not recited in any one of the independent claims representing the broadest concepts of the present invention are described as optional structural elements.

Each drawing is a schematic and does not necessarily provide precise depiction. The substantially same structural elements are given the same reference signs throughout the drawings, and their detailed description is omitted or simplified.

### EMBODIMENT

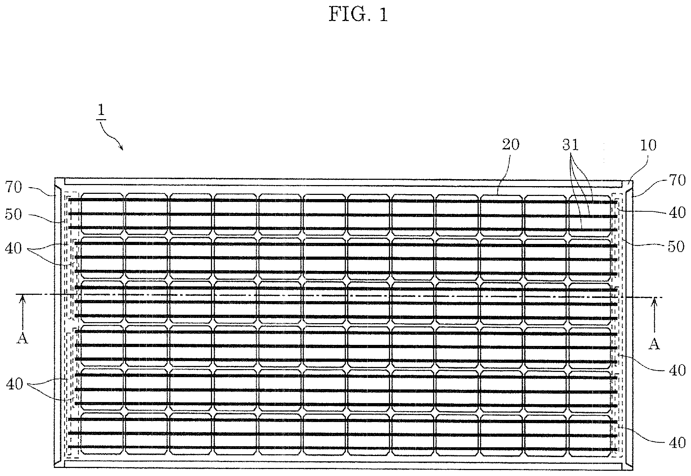

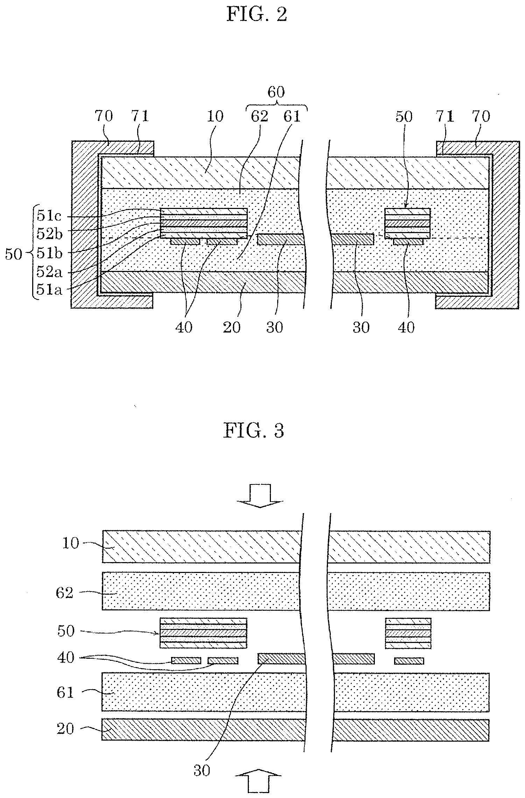

The structure of solar cell module 1 according to the embodiment is described first, with reference to FIGS. 1 and 2. FIG. 1 is a plan view of the solar cell module according to the embodiment. FIG. 2 is a partially enlarged sectional view of the solar cell module along line A-A in FIG. 1.

As illustrated in FIGS. 1 and 2, solar cell module 1 includes substrate 10, back sheet 20, plurality of solar cells 30, transition wire 40, concealment sheet 50, and filling member 60. Solar cell module 1 in this embodiment further includes frame 70. Solar cell module 1 has a structure in which solar cells 30 are sealed with filling member 60 between substrate 10 and back sheet 20 that face each other.

As illustrated in FIG. 1, solar cell module 1 is, for example, rectangular in planar view. As an example, solar cell module 1 is a rectangle of about 1600 mm in horizontal length and about 800 mm in vertical length. The shape of solar cell module 1 is not limited to a rectangle.

The following describes each structural member of solar cell module 1 in detail.

### [Substrate]

Substrate 10 is a light-transmitting substrate, and is, for example, a glass substrate (transparent glass substrate) made of a transparent glass material. Substrate 10 is not limited to a glass substrate, and may be, for example, a resin substrate made of a light-transmitting resin material such as a transparent resin material.

Substrate 10 is a front surface protection member for protecting the front surface of solar cell module 1, and protects the inside of solar cell module 1 from the external environment such as the wind and rain, external impact, and fire. In this embodiment, substrate 10 is located on the light receiving surface side of solar cells 30, and sunlight enters from the substrate 10 side. The surface (exposed surface) of substrate 10 is thus the light receiving surface. An antireflection coating may be formed on the surface of substrate 10, to make substrate 10 a low-reflection substrate.

### [Back sheet]

Back sheet 20 is a back surface protection member for protecting the back surface of solar cell module 1, and protects the inside of solar cell module 1 from the external environment. Back sheet 20 is, for example, a resin sheet made of polyethylene terephthalate (PET) or polyethylene naphthalate (PEN).

In this embodiment, the color of back sheet 20 is black. The color of back sheet 20 may be, however, other than black. Back sheet 20 is not limited to be made of resin, and may be made of glass.

### [Solar cell (solar cell element)]

Solar cell 30 is a photoelectric conversion element (photovoltaic element) for converting light such as sunlight into electricity. As illustrated in FIG. 1, plurality of solar cells 30 are arranged in a matrix on the same plane to form a cell array. As illustrated in FIG. 2, plurality of solar cells 30 (cell array) are arranged between substrate 10 and back sheet 20.

Plurality of solar cells 30 arranged in one of the row direction and column direction are made into a cell string (solar cell group) by electrically connecting adjacent solar cells 30 by conductive tab wire (interconnector) 31. Plurality of solar cells 30 in the cell string are connected in series. Tab wire 31 may be, for example, made by cutting metal foil, such as copper foil or silver foil, the entire surface of which is coated with solder, in strip form with a predetermined length.

In this embodiment, plurality of solar cells 30 arranged in the row direction are connected by tab wire 31 to form a cell string. In this case, the respective electrodes of adjacent solar cells 30 are connected in sequence by three tab wires 31 through solder or the like, thus creating a cell string in which plurality of solar cells 30 are connected in a line.

In FIG. 1, each solar cell 30 is connected with three tab wires 31, and twelve solar cells 30 are connected along the row direction to constitute one cell string. Six cell strings are formed in FIG. 1.

### [Transition wire (transition tab)]

Transition wire 40 is horizontal wiring common-connecting tab wires 31 connected to plurality of solar cells 30. Transition wire 40 may be, for example, made by cutting metal foil, such as copper foil or silver foil, the entire surface of which is coated with solder, in strip form with a predetermined length.

As illustrated in FIG. 1, transition wire 40 is provided at both ends of solar cell module 1 in the longitudinal direction. In this embodiment, four transition wires 40 are provided at one end (left end in FIG. 1) of solar cell module 1 in the longitudinal direction, and three transition wires 40 are provided at the other end (right end in FIG. 1) of solar cell module 1 opposite to the one end in the longitudinal direction.

The first solar cell 30 in each cell string is electrically connected to transition wires 40 via tab wires 31, in the vicinity of the one end of solar cell module 1 in the longitudinal direction. The last solar cell 30 in each cell string is electrically connected to transition wires 40 via tab wires 31, in the vicinity of the other end of solar cell module 1 in the longitudinal direction.

Thus, the plurality of (six in FIG. 1) cell strings are connected in series or in parallel to constitute the cell array. In other words, all solar cells 30 in solar cell module 1 are connected in series or in parallel.

### [Concealment sheet]

Concealment sheet 50 covers transition wires 40 from the substrate 10 side, in order to conceal transition wires 40. Hence, concealment sheet 50 overlaps transition wires 40 and is greater in size than transition wires 40 in planar view, as illustrated in FIG. 1.

In this embodiment, transition wires 40 are provided at both ends of solar cell module 1 in the longitudinal direction, i.e. at two locations that are the one end and other end in the longitudinal direction. Concealment sheet 50 is accordingly provided at both ends of solar cell module 1 in the longitudinal direction.

In this embodiment, concealment sheet 50 provided at the one end (left end in FIG. 1) of solar cell module 1 in the longitudinal direction covers all (four in FIG. 1) transition wires 40 located at the one end together. Concealment sheet 50 provided at the other end (right end in FIG. 1) of solar cell module 1 in the longitudinal direction covers all (three in FIG. 1) transition wires 40 located at the other end together.

As illustrated in FIG. 2, concealment sheet 50 has a stack structure of a plurality of layers, and includes: first sheet layer 51a in contact with filling member 60; and second sheet layer 51b placed over first sheet layer 51a. Concealment sheet 50 in this embodiment further includes third sheet layer 51c placed over second sheet layer 51b. Concealment sheet 50 thus has a stack structure of three sheet layers. As an example, first sheet layer 51a and third sheet layer 51c each have a layer thickness of 30 pm, and second sheet layer 51b has a layer thickness of 50 µm.

First sheet layer 51a and second sheet layer 51b are made of any of: a material of the same type of color as the material of back sheet 20 or filling member 60 (back sheet side filling member 61); a transparent material; and a semitransparent material.

In this embodiment, first sheet layer 51a is made of a transparent material. Second sheet layer 51b is made of a material of the same type of color as the material of back sheet 20 or filling member 60 (back sheet side filling member 61), and is made of a black material to match the color of back sheet 20 in this embodiment. Third sheet layer 51c is made of the same material (transparent material) as first sheet layer 51.

Thus, in this embodiment, given that the color of back sheet 20 or filling member 60 which is the background color of concealment sheet 50 is black, a layer of white color which is noticeable in the case where the background color is black is not used in any of the sheet layers included in concealment sheet 50.

In this embodiment, first sheet layer 51a is a resin sheet (PE sheet) made of polyethylene (PE), and second sheet layer 51b is a resin sheet (PET sheet) made of polyethylene terephthalate (PET). Third sheet layer 51c is made of the same material as first sheet layer 51a, and is a resin sheet (PE sheet) made of polyethylene (PE) in this embodiment.

First sheet layer 51a has adhesiveness to filling member 60. This enables first sheet layer 51a and filling member 60 to adhere to each other, without interposing an additional adhesive in between.

In detail, first sheet layer 51a has adhesiveness to filling member 60 filling the space between transition wires 40 and concealment sheet 50. In this embodiment, first sheet layer 51a is in contact with back sheet side filling member 61, and has adhesiveness to back sheet side filling member 61. This enables first sheet layer 51a and back sheet side filling member 61 to adhere to each other without using an adhesive.

An experiment by the present inventors revealed that polyethylene (PE) and ethylene vinyl acetate (EVA) adhered to each other without using an additional adhesive. Accordingly, first sheet layer 51a made of PE and back sheet side filling member 61 made of EVA adhere to each other without using an adhesive.

Third sheet layer 51c also has adhesiveness to filling member 60. This enables third sheet layer 51c and filling member 60 to adhere to each other, without interposing an additional adhesive in between.

In detail, third sheet layer 51c has adhesiveness to filling member 60 filling the space between substrate 10 and concealment sheet 50. In this embodiment, third sheet layer 51c is in contact with substrate side filling member 62, and has adhesiveness to substrate side filling member 62. This enables third sheet layer 51c and substrate side filling member 62 to adhere to each other without using an adhesive.

Polyethylene (PE) and ethylene vinyl acetate (EVA) adhere to each other as mentioned above, and so third sheet layer 51c made of PE and substrate side filling member 62 made of EVA adhere to each other without using an adhesive. In this embodiment, first sheet layer 51a and third sheet layer 51c adhere to and merge with filling member 60 after a lamination process.

In this embodiment, the material of second sheet layer 51b is PET. This realizes concealment sheet 50 having favorable long-term reliability and necessary strength (stiffness) in appearance. The use of PET as the material of second sheet layer 51b also facilitates operation in the manufacturing process. In detail, in the manufacturing process, substrate 10 (glass), substrate side filling member 62, and transition wires 40 are stacked in this order, and concealment sheet 50 is inserted between substrate side filling member 62 and transition wires 40. For example, transition wires 40 are lifted with tweezers, and concealment sheet 50 is inserted into the gap between transition wires 40 and substrate side filling member 62. Here, the use of PET with relatively high strength as the material of second sheet layer 51b facilitates the operation of inserting concealment sheet 50.

Concealment sheet 50 further includes: first adhesion layer 52a for causing first sheet layer 51a and second sheet layer 51b to adhere to each other; and second adhesion layer 52b for causing second sheet layer 51b and third sheet layer 51c to adhere to each other.

Inserting first adhesion layer 52a between first sheet layer 51a and second sheet layer 51b eases the adhesion between first sheet layer 51a and second sheet layer 51b. Inserting second adhesion layer 52b between second sheet layer 51b and third sheet layer 51c eases the adhesion between second sheet layer 51b and third sheet layer 51c.

In this embodiment, the color of first adhesion layer 52a and second adhesion layer 52b is black to match the color of back sheet 20.

Thus, in this embodiment, given that the color of back sheet 20 or filling member 60 which is the background color of concealment sheet 50 is black, a layer of white color which is noticeable in the case where the background color is black is not used in any of the resin layers included in concealment sheet 50, either.

Concealment sheet 50 having the aforementioned structure can be produced in the following manner. For example, a structure obtained by bonding three plate-like sheet layers of plate-like first sheet layer 51a, plate-like second sheet layer 51b, and plate-like third sheet layer 51c by adhesion with two adhesion layers of first adhesion layer 52a and second adhesion layer 52b is cut in strip form with a predetermined length. Since concealment sheet 50 in this embodiment covers plurality of transition wires 40 located at each of both ends of solar cell module 1 in the longitudinal direction together, the length of concealment sheet 50 is approximately the length of the short side of solar cell module 1.

### [Filling member]

Filling member (filler) 60 is located between substrate 10 and back sheet 20. In this embodiment, filling member 60 fills the space between substrate 10 and back sheet 20. Solar cells 30 are thus sealed with filling member 60.

Filling member 60 is formed by performing a lamination process (lamination) on the two filling members sandwiching solar cells 30. The lamination process is described below, with reference to FIG. 3. FIG. 3 is a view for describing the lamination process in the solar cell module according to the embodiment.

As illustrated in FIG. 3, the plurality of cell strings composed of plurality of solar cells 30 are sandwiched between back sheet side filling member 61 and substrate side filling member 62, and back sheet 20 and substrate 10 are placed below and above the sandwich structure, to prepare a predetermined stack body.

The stack body is then subjected to thermocompression bonding (heating and pressing) in a vacuum at a temperature of 100°C or higher as an example. As a result, back sheet side filling member 61 and substrate side filling member 62 are heated to melt, and form filling member 60.

By performing such a lamination process, the space between substrate 10 and back sheet 20 is filled with filling member 60, and solar cells 30, transition wires 40, and concealment sheet 50 are sealed with filling member 60.

Back sheet side filling member (first filling member) 61 is a sheet located between back sheet 20 and each of: plurality of solar cells 30; and transition wires 40, and mainly fills the space between back sheet 20 and transition wires 40 and solar cells 30 as a result of the lamination process.

Substrate side filling member (second filling member) 62 is a sheet located between substrate 10 and each of: plurality of solar cells 30; and concealment sheet 50, and mainly fills the space between substrate 10 and solar cells 30 and concealment sheet 50 as a result of the lamination process.

Each of back sheet side filling member 61 and substrate side filling member 62 is, for example, a resin sheet made of a resin material, and is an EVA sheet made of ethylene vinyl acetate (EVA) in this embodiment. The color of back sheet side filling member 61 and substrate side filling member 62 is, for example, black. The color of filling member 60 is therefore black.

### [Frame]

Frame 70 is an outer frame covering the peripheral edges of solar cell module 1. Frame 70 in this embodiment is an aluminum frame made of aluminum. As illustrated in FIG. 1, four frames 70 are attached to the respective edges of the four sides of solar cell module 1.

As illustrated in FIG. 2, for example, frame 70 is bonded to the edge of each side of solar cell module 1 by adhesive 71 made of silicone resin.

The solar cell module is provided with a terminal box for extracting power generated in solar cells 30, although not illustrated. For example, the terminal box is fixed to back sheet 20, and contains a plurality of circuit components mounted on a circuit substrate.

### [Advantageous effects, etc.]

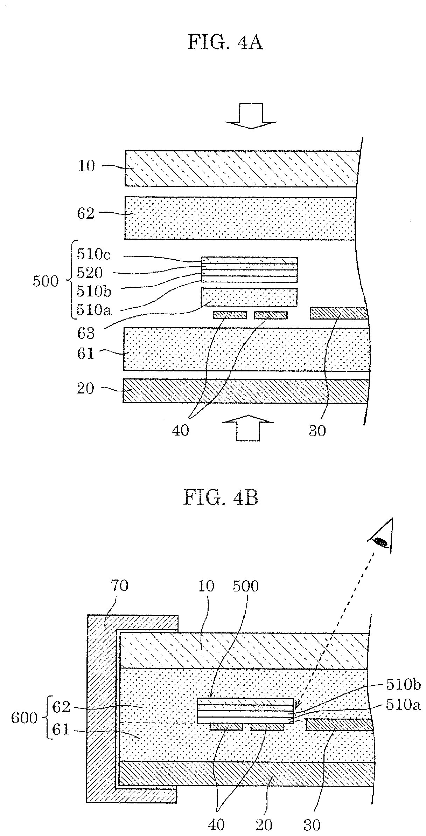

The following describes the advantageous effects of solar cell module 1 according to this embodiment together with the circumstances leading to the present invention, with reference to FIGS. 4A and 4B illustrating a comparative example. FIGS. 4A and 4B are sectional views illustrating the structure of a solar cell module according to the comparative example. FIG. 4A illustrates the structure before the lamination process, and FIG. 4B illustrates the structure after the lamination process.

In the solar cell module, the first and last solar cells in each cell string are connected to the transition wires via the tab wires. Here, the transition wires have metallic luster, and so are noticeable in the case where the solar cell module is seen from the glass substrate side. This causes poor design of the solar cell module as a whole.

In view of this, the present inventors studied covering transition wires 40 with concealment sheet 500 from the substrate 10 side (light receiving surface side) to conceal transition wires 40, as illustrated in FIGS. 4A and 4B.

Concealment sheet 500 studied here had a structure in which stack PET composed of first sheet layer 510a (38 µm) made of PET and second sheet layer 510b (50 µm) made of PET was caused to adhere to third sheet layer 510c made of PE by adhesion layer 520. First sheet layer 510a and second sheet layer 510b were white, third sheet layer 510c was transparent, and adhesion layer 520 was black.

The introduction of concealment sheet 500 was thus studied in order to improve design. However, providing concealment sheet 500 ended up rather degrading design. This is described in detail below.

The materials and colors of first sheet layer 510a, second sheet layer 510b, adhesion layer 520, and third sheet layer 510c in concealment sheet 500 were selected as mentioned above, for color matching with back sheet 20 and the like.

However, due to the presence of black color of back sheet 20 or filling member 600 as the background color of concealment sheet 500, the edges of white first sheet layer 510a and white second sheet layer 510b were visible from the light receiving surface depending on the angle from which the solar cell module was seen, as illustrated in FIG. 4B. In other words, white lines (streaky white lines) could be visible along the longitudinal direction of concealment sheet 500, causing poor design.

In particular, while concealment sheet 500 was formed by cutting the stacked sheet layers to a predetermined length, in the case where the cutting state was poor, the edges of first sheet layer 510a and white second sheet layer 510b protruded (were exposed), making white lines very visible.

Thus, the present inventors found out as a result of the study that placing concealment sheet 500 having the aforementioned structure rather degraded design.

The present inventors also found out that the use of concealment sheet 500 having the aforementioned structure caused lower workability and higher cost. This is described in detail below.

As illustrated in FIG. 4A, in the case of using concealment sheet 500 having the aforementioned structure, concealment filling member 63 needed to be placed between concealment sheet 500 and transition wires 40. In other words, concealment sheet 500 needed to adhere to transition wires 40 through concealment filling member 63.

This increased the number of parts, and led to lower workability and higher cost. Concealment filling member 63 was, for example, made of the same material (EVA sheet) as back sheet side filling member 61 and substrate side filling member 62.

The present invention was made based on such findings. As a result of keen examination, the present inventors discovered that the use of concealment sheet 50 having the structure illustrated in FIG. 2 can conceal transition wires 40 without degrading design and workability.

In detail, concealment sheet 50 used in solar cell module 1 in this embodiment includes: first sheet layer 51a in contact with at least filling member 60; and second sheet layer 51b placed over first sheet layer 51a.

First sheet layer 51a and second sheet layer 51b are made of any of: a material of the same type of color as the material of back sheet 20 or filling member 60; a transparent material; and a semitransparent material.

This makes the color of back sheet 20 or filling member 60, which is the background color of concealment sheet 50, the same type of color as concealment sheet 50 or unnoticeable, so that the edges of concealment sheet 50 are not visible.

In particular, concealment sheet 50 is not noticeable even in the case where the edges of first sheet layer 51a and second sheet layer 51b protrude from concealment sheet 50 due to a poor cutting state of concealment sheet 50.

Therefore, not only transition wires 40 can be concealed by concealment sheet 50, but also concealment sheet 50 can be made unnoticeable regardless of the cutting state of concealment sheet 50. This improves the design of the whole appearance of solar cell module 1.

Moreover, in this embodiment, first sheet layer 51a has adhesiveness to filling member 60, and so concealment filling member 63 in the comparative example in FIG. 4A can be substituted by first sheet layer 51a.

In particular, since first sheet layer 51a in this embodiment is made of polyethylene (PE), concealment filling member 63 made of EVA can be easily substituted by first sheet layer 51a made of PE.

Concealment sheet 50 can thus adhere to filling member 60 without using concealment filling member 63. This prevents an increase in the number of parts, and therefore prevents lower workability and higher cost.

As described above, solar cell module 1 according to this embodiment can conceal transition wires 40 without degrading design and workability.

Moreover, in this embodiment, first sheet layer 51a is made of the transparent material or the semitransparent material, and second sheet layer 51b has the same type of color as back sheet 20 or filling member 60. In detail, back sheet 20 or filling member 60 is black, and second sheet layer 51b is black, too.

Thus, in this embodiment, concealment sheet 50 has no white layer. This avoids such a situation where, due to the black background color of back sheet 20 or filling member 60, white lines of the concealment sheet are visible in the case where the concealment sheet has a white layer.

Moreover, in this embodiment, concealment sheet 50 further includes third sheet layer 51c placed over second sheet layer 51b, and third sheet layer 51c is made of the same material as first sheet layer 51a.

In this way, transition wires 40 can be concealed without degrading design and workability, even in the case where concealment sheet 50 further includes third sheet layer 51c.

Moreover, in this embodiment, substrate side filling member 62 fills the space between concealment sheet 50 and substrate 10, and third sheet layer 51c is in contact with substrate side filling member 62 and has adhesiveness to substrate side filling member 62.

This eases the adhesion of concealment sheet 50 to substrate side filling member 62, too. Workability in the case of using concealment sheet 50 is further improved as a result.

### (Variations, etc.)

While the solar cell module according to the present invention has been described above by way of the embodiment, the present invention is not limited to the foregoing embodiment.

For example, although the foregoing embodiment describes the case where concealment sheet 50 has no white layer because back sheet 20 and filling member 60 are black, concealment sheet 50 may have no black layer in the case where back sheet 20 and filling member 60 are white.

Other modifications obtained by applying various changes conceivable by a person skilled in the art to each of the embodiments and any combinations of the structural elements and functions in the embodiments without departing from the scope of the present invention are also included in the present invention.

### REFERENCE MARKS IN THE DRAWINGS

- 1: solar cell module
- 10: substrate
- 20: back sheet
- 30: solar cell
- 31: tab wire
- 40: transition wire
- 50, 500: concealment sheet
- 51a, 510a: first sheet layer
- 51b, 510b: second sheet layer
- 51c, 510c: third sheet layer
- 52a: first adhesion layer
- 52b: second adhesion layer
- 60, 600: filling member
- 61: back sheet side filling member
- 62: substrate side filling member
- 63: concealment filling member
- 70: frame
- 520: adhesion layer

## Claims

1. A solar cell module (1) comprising:
a light-transmitting substrate (10);
a back sheet (20);
a plurality of solar cells (30) arranged between the substrate (10) and the back sheet (20);
a transition wire (40) connecting tab wires together, the tab wires being connected to the plurality of solar cells (30);
a concealment sheet (50) covering the transition wire (40) from a substrate side; and
a filling member (60) filling a space between the substrate (10) and the back sheet (20) comprising a substrate side filling member (62) filling a space between the concealment sheet (50) and the substrate (10),
wherein the transition wire (40) is disposed in the filling member (60),
wherein the concealment sheet (50) includes: a first sheet layer (51a) in contact with the filling member (60); a second sheet layer (51 b) placed over the first sheet layer (51a) on the substrate side; and a third sheet layer (51c) placed over the second sheet layer (51b) on the substrate side,
the first sheet layer (51a) is made of a transparent material or a semitransparent material,
the second sheet layer (51b) is made of a material of the same type of color as a material of the back sheet (20) or the filling member (60),
the first sheet layer (51a) has adhesiveness to the filling member (60), and
wherein the third sheet layer (51c) is in contact with the substrate side filling member (62), and has adhesiveness to the substrate side filling member (62).

2. The solar cell module (1) according to claim 1,
wherein the back sheet (20) or the filling member (60) is black, and
the second sheet layer (51b) is black.

3. The solar cell module according to claim 2,
wherein the concealment sheet (50) further includes a first adhesion layer (52a) that causes the first sheet layer (51a) and the second sheet layer (51b) to adhere to each other, and
the first adhesion layer (52a) is black.

4. The solar cell module (1) according to claim 3,
wherein the concealment sheet (50) further includes: a second adhesion layer (52b) that causes the second sheet layer (51 b) and the third sheet layer (51c) to adhere to each other.

5. The solar cell module according to claim 4,
wherein the third sheet layer is made of the same material as the first sheet layer (51a).

6. The solar cell module (1) according to any one of claim 1 to claim 5,
wherein the first sheet layer (51a) is made of polyethylene,
the second sheet layer (51b) is made of polyethylene terephthalate, and
the filling member (60) is made of ethylene vinyl acetate.

7. A method for manufacturing a solar cell module (1) according to claim 1 including a light-transmitting substrate (10) and a back sheet (20), the method comprising
arranging, between the substrate (10) and the back sheet (20): a plurality of solar cells (30); a transition wire (40) connecting tab wires together, the tab wires being connected to the plurality of solar cells (30); a concealment sheet (50) covering the transition wire (40) from a substrate side; and a filling member (60) filling a space between the substrate (10) and the back sheet (20) comprising a substrate side filling member (62) filling space between the concealment sheet (50) and the substrate (10), wherein the concealment sheet (50) includes: a first sheet layer (51a) in contact with the filling member; and a second sheet layer (51b) placed over the first sheet layer (51a) on the substrate side; and a third sheet layer (51c) placed over the second sheet layer (51b) on the substrate side, the first sheet layer (51a) is made of a transparent material or a semitransparent material, the second sheet layer (51b) is made of a material of the same type of color as a material of the back sheet (20) or the filling member (60), the first sheet layer (51a) has adhesiveness to the filling member (60), and wherein the third sheet layer (51c) is in contact with the substrate side filling member (62), and has adhesiveness to the substrate side filling member (62).

8. The method for manufacturing the solar cell module (1) according to claim 7, the method further comprising:
heating and pressing in a vacuum the stack body prepared by said step of arranging, between the substrate (10) and the back sheet (20), the plurality of solar cells (30), the transition wire (40), the concealment sheet (50) and the filling member (60).

9. The method for manufacturing the solar cell module (1) according to any one of claims 7 or 8, wherein the back sheet (20) or the filling member (60) is black, and
the second sheet layer (51b) is black.

10. The method for manufacturing the solar cell module (1) according to claim 9, wherein the concealment sheet (50) further includes a first adhesion layer (52a) that causes the first sheet layer (51a) and the second sheet layer (51b) to adhere to each other, and
the first adhesion layer (52a) is black.

11. The method for manufacturing the solar cell module (1) according to any one of claim 7 to claim 10, wherein the first sheet layer (51a) and the third sheet layer (51c) are made of polyethylene,
the second sheet layer (51b) is made of polyethylene terephthalate, and
the filling member (60) is made of ethylene vinyl acetate.

## Patentansprüche

1. Solarzellenmodul (1) umfassend:
ein lichtübertragendes bzw. lichtdurchlässiges Substrat (10);
eine hintere Lage (20);
eine Mehrzahl von Solarzellen (30), die zwischen dem Substrat (10) und der hinteren Lage (20) angeordnet sind;
einen Übergangsdraht (40), der Kopplungs- bzw. Verbindungsdrähte miteinander verbindet, wobei die Kopplungs- bzw. Verbindungsdrähte mit der Mehrzahl von Solarzellen (30) verbunden sind;
eine Verdeckungslage (50), die den Übergangsdraht (40) von einer Substratseite aus verdeckt; und
ein Füllglied (60), das einen Raum zwischen dem Substrat (10) und der hinteren Lage (20) füllt, umfassend ein substratseitiges Füllglied (62), das einen Raum zwischen der Verdeckungslage (50) und dem Substrat (10) füllt,
wobei der Übergangsdraht (40) in dem Füllglied (60) angeordnet ist,
wobei die Verdeckungslage (50) enthält: eine erste Lagenschicht (51a) in Kontakt mit dem Füllglied (60); eine zweite Lagenschicht (51b), die über der ersten Lagenschicht (51a) auf der Substratseite platziert ist; und eine dritte Lagenschicht (51c), die über der zweiten Lagenschicht (51b) auf der Substratseite platziert ist,
wobei die erste Lagenschicht (51a) aus einem transparenten Material oder einem semitransparenten Material besteht,
wobei die zweite Lagenschicht (51b) aus einem Material der gleichen Art von Farbe wie ein Material hinteren Lage (20) oder des Füllglieds (60) besteht,
wobei die erste Lagenschicht (51a) an dem Füllglied (60) haftet, und
wobei die dritte Lagenschicht (51c) mit dem substratseitigen Füllglied (62) in Kontakt ist und an dem substratseitigen Füllglied (62) haftet.

2. Solarzellenmodul (1) nach Anspruch 1,
wobei die hintere Lage (20) oder das Füllglied (60) schwarz ist, und
die zweite Lagenschicht (51b) schwarz ist.

3. Solarzellenmodul nach Anspruch 2,
wobei die Verdeckungslage (50) ferner eine erste Haftschicht (52a) enthält, die bewirkt, dass die erste Lagenschicht (51a) und die zweite Lagenschicht (51b) aneinander haften, und
die erste Haftschicht (52a) schwarz ist.

4. Solarzellenmodul (1) nach Anspruch 3,
wobei die Verdeckungslage (50) ferner enthält: eine zweite Haftschicht (52b), die bewirkt, dass die zweite Lagenschicht (51b) und die dritte Lagenschicht (51c) aneinander haften.

5. Solarzellenmodul nach Anspruch 4,
wobei die dritte Lagenschicht aus dem gleichen Material wie die erste Lagenschicht (51a) besteht.

6. Solarzellenmodul (1) nach einem der Ansprüche 1 bis 5;
wobei die erste Lagenschicht (51a) aus Polyethylen besteht,
die zweite Lagenschicht (51b) aus Polyethylenterephthalat besteht, und
das Füllglied (60) aus Ethylenvinylacetat besteht.

7. Verfahren zum Herstellen eines Solarzellenmoduls (1) nach Anspruch 1, das ein lichtübertragendes bzw. lichtdurchlässiges Substrat (10) und eine hinteren Lage (20) enthält, wobei das Verfahren umfasst:
Anordnen, zwischen dem Substrat (10) und der hinteren Lage (20): eine Mehrzahl von Solarzellen (30); einen Übergangsdraht (40), der Kopplungs- bzw. Verbindungsdrähte miteinander verbindet, wobei die Kopplungs- bzw. Verbindungsdrähte mit der Mehrzahl von Solarzellen (30) verbunden sind; eine Verdeckungslage (50), die den Übergangsdraht (40) von einer Substratseite aus bedeckt; und ein Füllglied (60), das einen Raum zwischen dem Substrat (10) und der hinteren Lage (20) füllt, umfassend ein substratseitiges Füllglied (62), das einen Raum zwischen der Verdeckungslage (50) und dem Substrat (10) füllt,
wobei die Verdeckungslage (50) enthält: eine erste Lagenschicht (51a) in Kontakt mit dem Füllglied; und eine zweite Lagenschicht (51b), die über der ersten Lagenschicht (51a) auf der Substratseite platziert ist; und eine dritte Lagenschicht (51c), die über der zweiten Lagenschicht (51b) auf der Substratseite platziert ist,
wobei die erste Lagenschicht (51a) aus einem transparenten Material oder einem semitransparenten Material besteht, die zweite Lagenschicht (51b) aus einem Material der gleichen Art von Farbe wie ein Material hinteren Lage (20) oder des Füllglieds (60) besteht, die erste Lagenschicht (51a) an dem Füllglied (60) haftet, und die dritte Lagenschicht (51c) mit dem substratseitigen Füllglied (62) in Kontakt ist und an dem substratseitigen Füllglied (62) haftet.

8. Verfahren zum Herstellen des Solarzellenmoduls (1) nach Anspruch 7, wobei das Verfahren ferner umfasst:
Erwärmen und Pressen, in einem Vakuum, des Stapelkörpers, der durch den Schritt des Anordnens der Mehrzahl von Solarzellen (30), des Übergangsdrahtes (40), der Verdeckungslage (40) und des Füllglieds (60) zwischen dem Substrat (10) und der hinteren Lage (20) hergestellt wird.

9. Verfahren zum Herstellen des Solarzellenmoduls (1) nach einem der Ansprüche 7 oder 8,
wobei die hintere Lage (20) oder das Füllglied (60) schwarz ist, und
die zweite Lagenschicht (51b) schwarz ist.

10. Verfahren zum Herstellen des Solarzellenmoduls (1) nach Anspruch 9,
wobei die Verdeckungslage (50) ferner eine erste Haftschicht (52a) enthält, die bewirkt, dass die erste Lagenschicht (51a) und die zweite Lagenschicht (51b) aneinander haften, und
die erste Haftschicht (52a) schwarz ist.

11. Verfahren zum Herstellen des Solarzellenmoduls (1) nach einem der Ansprüche 7 bis 10;
wobei die erste Lagenschicht (51a) und die dritte Lagenschicht (51c) aus Polyethylen bestehen,
die zweite Lagenschicht (51b) aus Polyethylenterephthalat besteht, und das Füllglied (60) aus Ethylenvinylacetat besteht.

## Revendications

1. Module de piles solaires (1) comprenant :
un substrat de transmission lumineuse (10) ;
une feuille arrière (20) ;
une pluralité de piles solaires (30) agencées entre le substrat (10) et la feuille arrière (20) ;
un fil de transition (40) connectant des languettes de connexion ensemble, les languettes de connexion étant connectées à la pluralité de piles solaires (30) ;
une feuille d'occultation (50) recouvrant le fil de transition (40) depuis un côté de substrat ; et
un élément de remplissage (60) remplissant un espace entre le substrat (10) et la feuille arrière (20) comprenant un élément de remplissage côté substrat (62) remplissant un espace entre la feuille d'occultation (50) et le substrat (10),
dans lequel le fil de transition (40) est disposé dans l'élément de remplissage (60),
dans lequel la feuille d'occultation (50) inclut : une première couche de feuille (51a) en contact avec l'élément de remplissage (60) ; une deuxième couche de feuille (51b) placée sur la première couche de feuille (51a) sur le côté de substrat ; et une troisième couche de feuille (51c) placée sur la deuxième couche de feuille (51b) sur le côté de substrat,
la première couche de feuille (51a) est réalisée en un matériau transparent ou un matériau semi-transparent,
la deuxième couche de feuille (51b) est réalisée en un matériau du même type de couleur qu'un matériau de la feuille arrière (20) ou de l'élément de remplissage (60),
la première couche de feuille (51a) a une adhésivité à l'élément de remplissage (60), et
dans lequel la troisième couche de feuille (51c) est en contact avec l'élément de remplissage côté substrat (62) et a une adhésivité à l'élément de remplissage côté substrat (62).

2. Module de piles solaires (1) selon la revendication 1,
dans lequel la feuille arrière (20) ou l'élément de remplissage (60) est noir(e), et la deuxième couche de feuille (51b) est noire.

3. Module de piles solaires selon la revendication 2,
dans lequel la feuille d'occultation (50) inclut en outre une première couche d'adhésion (52a) qui amène la première couche de feuille (51a) et la deuxième couche de feuille (51b) à adhérer l'une à l'autre, et
la première couche d'adhésion (52a) est noire.

4. Module de piles solaires (1) selon la revendication 3,
dans lequel la feuille d'occultation (50) inclut en outre : une seconde couche d'adhésion (52b) qui amène la deuxième couche de feuille (51b) et la troisième couche de feuille (51c) à adhérer l'une à l'autre.

5. Module de piles solaires selon la revendication 4,
dans lequel la troisième couche de feuille est réalisée en le même matériau que la première couche de feuille (51a).

6. Module de piles solaires (1) selon l'une quelconque de la revendication 1 à la revendication 5,
dans lequel la première couche de feuille (51a) est réalisée en polyéthylène,
la deuxième couche de feuille (51b) est réalisée en polyéthylène téréphtalate, et
l'élément de remplissage (60) est réalisé en acétate de vinyle-éthylène.

7. Procédé de fabrication d'un module de piles solaires (1) selon la revendication 1, incluant un substrat de transmission lumineuse (10) et une feuille arrière (20), le procédé comprenant
agencer, entre le substrat (10) et la feuille arrière (20) : une pluralité de piles solaires (30) ; un fil de transition (40) connectant des languettes de connexion ensemble, les languettes de connexion étant connectées à la pluralité de piles solaires (30) ; une feuille d'occultation (50) recouvrant le fil de transition (40) depuis un côté de substrat ; et un élément de remplissage (60) remplissant un espace entre le substrat (10) et la feuille arrière (20) comprenant un élément de remplissage côté substrat (62) remplissant un espace entre la feuille d'occultation (50) et le substrat (10),
dans lequel la feuille d'occultation (50) inclut : une première couche de feuille (51a) en contact avec l'élément de remplissage ; et une deuxième couche de feuille (51b) placée sur la première couche de feuille (51a) sur le côté de substrat ; et une troisième couche de feuille (51c) placée sur la deuxième couche de feuille (51b) sur le côté de substrat,
la première couche de feuille (51a) est réalisée en un matériau transparent ou un matériau semi-transparent, la deuxième couche de feuille (51b) est réalisée en un matériau du même type de couleur qu'un matériau de la feuille arrière (20) ou de l'élément de remplissage (60), la première couche de feuille (51a) a une adhésivité à l'élément de remplissage (60), et dans lequel la troisième couche de feuille (51c) est en contact avec l'élément de remplissage côté substrat (62) et a une adhésivité à l'élément de remplissage côté substrat (62).

8. Procédé de fabrication du module de piles solaires (1) selon la revendication 7, le procédé comprenant en outre :
chauffer et presser dans un vide le corps de pile préparé par ladite étape d'agencement, entre le substrat (10) et la feuille arrière (20), la pluralité de piles solaires (30), le fil de transition (40), la feuille d'occultation (50) et l'élément de remplissage (60).

9. Procédé de fabrication du module de piles solaires (1) selon l'une quelconque des revendications 7 ou 8,
dans lequel la feuille arrière (20) ou l'élément de remplissage (60) est noir(e), et la deuxième couche de feuille (51b) est noire.

10. Procédé de fabrication du module de piles solaires (1) selon la revendication 9,
dans lequel la feuille d'occultation (50) inclut en outre une première couche d'adhésion (52a) qui amène la première couche de feuille (51a) et la deuxième couche de feuille (51b) à adhérer l'une à l'autre, et
la première couche d'adhésion (52a) est noire.

11. Procédé de fabrication du module de piles solaires (1) selon l'une quelconque de la revendication 7 à la revendication 10,
dans lequel la première couche de feuille (51a) et la troisième couche de feuille (51c) sont réalisées en polyéthylène,
la deuxième couche de feuille (51b) est réalisée en polyéthylène téréphtalate, et l'élément de remplissage (60) est réalisé en acétate de vinyle-éthylène.
